# EUROPEAN PATENT SPECIFICATION

(11) **EP 0 439 750 B1**
(45) Date of publication and mention of the grant of the patent: **19.03.1997**
(21) Application number: 90124051.5
(22) Date of filing: 13.12.1990
(51) Int. Cl.: H01L 39/24, H01L 39/22

(54) **Semiconductor superconductor integrated circuit technology**
Halbleiter-Supraleiter integrierte Schaltungstechnik
Technique de circuit intégré semi-conducteur-supra-conducteur

(30) Priority: 01.02.1990 US 473483
(43) Date of publication of application: 07.08.1991
(73) Proprietor: International Business Machines Corporation, Armonk, N.Y. 10504 (US)
(72) Inventor: Chaudhari, Praveen, Briarcliff Manor, New York 10510 (US); Gambino, Richard Joseph, Yorktown Heights, New York 10598 (US); Koch, Roger Hilsen, Amawalk, New York 10501 (US); Laibowitz, Robert Benjamin, Peekskill, New York 10566 (US); Patton, Gary Lee, Poughkeepsie, New York 12603 (US); Sai-Halasz, George Anthony, Mount Kisco, New York 10549 (US); Stork, Johannes M. Cornelius, Yorktown Heights, New York 10598 (US)
(74) Representative: Schäfer, Wolfgang, Dipl.-Ing.

(56) References cited:
- EP-A- 0 282 012
- EP-A- 0 295 708
- EP-A- 0 357 321
- EP-A- 0 413 333
- APPLIED PHYSICS LETTERS, vol. 49, no. 25, 22nd December 1986, pages 1741-1743, New York, US; A.W. KLEINSASSER et al.: "n-InAs/GaAs heterostructuresuperconducting weak links with Nb electrodes"

## Description

The invention relates to providing high performance in both speed and density in integrated circuit technology.

With the progressively more demanding specifications in integrated circuit technology, a number of conflicting situations are being encountered. The density requirements are resulting in smaller devices having faster response times combined with more closely packed interwiring. Such requirements however make more difficult the reduction of parasitic resistance and capacitance at the many points where such parasitic resistance and capacitance can affect performance in the overall structure. Each instance where conductors with a voltage between them are moved closer to each other, the effect of parasitic resistance and capacitance becomes greater. Similarly, the smaller the cross section of a conductor, the greater the resistance. With devices, the goals of increased response time by making the device smaller are becoming more difficult to achieve because there are limits in many integrated circuits on reducing the parasitic resistances and capacitances. The combined effects of these limitations are making increased performance difficult to achieve.

A reduction of parasitic resistences is already proposed in EP 0 282 012 A2. This document teaches the use of high T_{c} superconductors for interwiring devices on a chip. To reduce the resistance this type of devices has to be operated at very low temperature. On the other hand it is well known, that semiconductor devices have only the designed characteristic within a limited temperature range. Devices are required to use with superconducting interwiring that also operate well at very low temperature. In particular the working temperature range should also be very large. The document does not give any disclosure on how such devices could be constructed. It mentions insulated gate field transistors, bipolar transistors and static electricity induction transistors. No teaching is available, what sort of devices is best suited and what design is required for optimum capability in this respect.

The EP 0 295 708 also discloses superconductive wiring. For connection of the interwiring to the devices additional non superconducting metal layers are also necessary. These metallic layers are not suitable in reducing the resistance as much as possible. Further the metal layers can lead to Schottky barriers together with the semiconductor material, what may result in undesired device switching capabilities.

The document also discloses field effect transistors as well as bipolar transistors without teaching, what sort of device is best suited for low temperature operation. In particular it discloses a bipolar transistor that is embedded in the substrate near the surface. According to the disclosed structure the base must always be connected with a metal.

Large capacities are also present between the transistor structure and the metal electrodes for connection. Therefore those skilled in the art will not consider this sort of devices as being best suited for semiconductor devices interwired with superconducting material.

The problem of the invention is to improve integrated circuit technology with superconducting interwiring by using the best suited device with a large operating temperature range and providing a structure of this device, that allows to keep parasitic capacitance and resistance low.

The problem is solved by a semiconductor integrated chip as claimed in the independent claim 1. Further improvements are featured in the dependent claims.

The invention as claimed in claim 1 provides the combined performance benefits of the type of device most responsive to performance gains with lower temperatures together with a class of conductor materials that are not only capable of radical downsizing but will also provide both that capability at a temperature compatible with device operation together with a broader processing window than materials normally used as conductors. The invention is particularly advantageous with Si/SIGe or GaAs/GaAlAs devices in integrated circuits using superconductors such as Y₁Ba₂Cu₃O₇, known in the art as an oxide superconductor, as interconnecting wiring, at least at the chip level interconnections.

For a better understanding of the present invention, together with further objects and advantages, a preferred embodiment of the invention is described in the following with reference to the accompanying drawings, in which:
FIG. 1 is a schematic sketch of a portion of an integrated circuit illustrating the devices and interconnecting wiring in the low temperature environment of the invention;
FIG. 2 is an enlarged schematic sketch of an interconnecting conductor.

In accordance with the invention, a radical improvement in downsizing, control of parasitic resistance and capacitance and device performance is achieved by providing higher temperature superconductor materials at at least the first or chip level interconnections coupled with the use of heterojunction semiconductor devices at an intermediate temperature below the transition temperature to superconductivity (T_{c}) of the superconductor. As an example, operation at 77 K of the Y₁Ba₂Cu₃O₇ oxide superconductor which has a T_{c} of approximately 94 K. The combination of these factors operates to provide devices which are most responsive to a lowering of temperature, in a temperature environment that is selected at a level that does not interfere with the performance of the junctions in the device, and further provides interconnect conductors that provide superconductivity or the ultimate in reduction of resistance and need for cross sectional area which then in turn reduces capacitance. The combination of these features operate to provide a radical improvement in the ability to build higher density devices, to radically downsize the conductors and simplifies many of the constraints being encountered heretofore in the art.

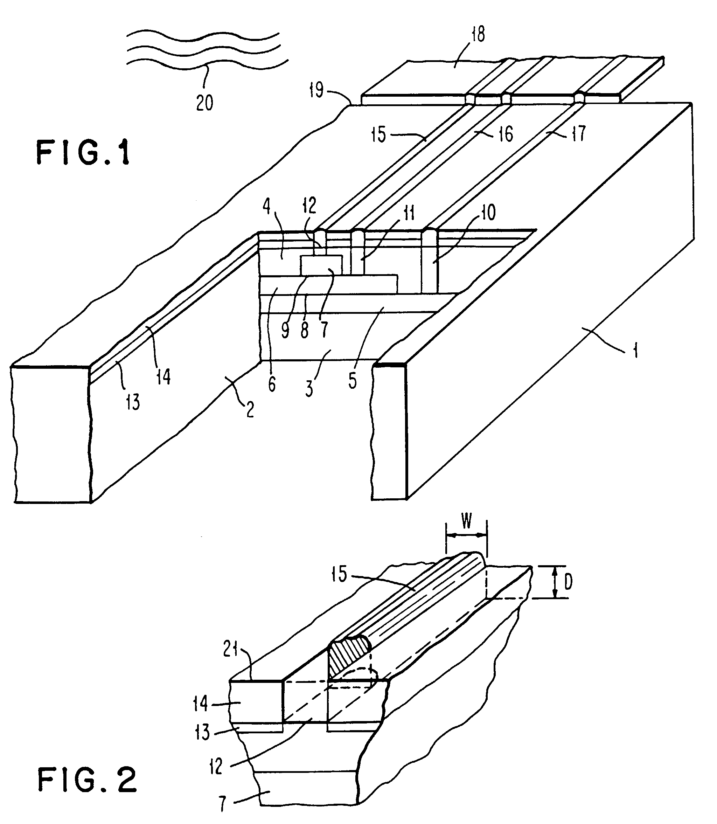

Referring to FIG. 1, a schematic sketch is provided illustrating the devices, and the conductors for interwiring the devices, in the environment of the invention. In FIG. 1, in a chip 1, a cut-out 2 is illustrated showing at the back of the cut-out the schematic cross section of a typical heterojunction device of the bipolar type. Heterojunction transistors are three terminal devices with different semiconducting materials forming p-n junctions and are generally of the bipolar and the field effect type. The bipolar has been selected as an illustration in that it generally has two conductors coming to the surface of the chip that are very close together so that the need for the radical conductor downsizing ability of the invention is somewhat pronounced in the case of the bipolar type device.

In FIG. 1, the device 4 is generally made up of a collector layer 5 within the chip with a base layer 6 superimposed thereon and an emitter layer 7 occupying a smaller area over the base layer 6, with heterojunctions, that is interfaces between semiconductors having different properties, for example, between GaAs and GaAlAs and between Si and Si/Ge, with the first interface being the collector-to-base junction 8 and the second one being the emitter-to-base junction 9. The heterojunction interfaces illustrated as 8 and 9 are responsible for the amplification property of the device and in accordance with the invention it has been found that devices of this type are most responsive to the lowering of temperature. The active regions 5, 6 and 7 of the transistor 4 have conductors 10, 11 and 12, respectively, rising to the surface. The conductor 10 going to the lowest level 5 or the collector in the crystal is usually an ion implant. The conductor 11 goes to the base 6. This conductor has the characteristic that it must be proximate to the emitter 7 but should not short out the emitter 7 or conductor 12. Thus, the size of conductors 11 and 12 is of importance. On the surface of the crystal 1 of the chip there may well be several layers, two of which 13 and 14, are shown for illustration purposes, and the conductors to the individual devices extend through those layers. The first layer 13 is generally a passivation layer to prevent impurities from getting into the sharp fields between electrodes on the surface and the second layer 14 placed over that is generally a planarization layer of insulating material that permits the laying down of further conductor patterns, not shown. The interwiring conductors for the example transistor of FIG. 1 are labelled elements 15, 16 and 17, extending from the conductors 10, 11 and 12, respectively, for the individual terminals of the transistor. These conductors are shown symbolically as further wiring 18 at the edge 19 of the chip. The superconductor interconnect wiring elements 15, 16 and 17 are further shown symbolically as being continued on the additional wiring plane 18.

In the art, there are a number of ways in which the wiring is handled, some with connections on the edge of the chip that go immediately outside of the environment of the chip and others such as the multilevel ceramic type construction where there are a plurality of levels as illustrated by element 18 all contained in the same environmental container. The superconductor interwired heterojunction transistor device in accordance with the invention is then operated below the T_{c} of the superconductor, for example, in the vicinity of liquid nitrogen which is around 77 K. The environmental condition is shown symbolically as element 20.

It will be apparent that the scale of FIG. 1 has no relation to the actual proportions since in typical chips in today's technology there are several hundred thousand transistors such as 4 that are all interwired.

A key aspect of the invention is the environment 20. In accordance with the invention, it has been found that the heterojunction transistor responds to lowering temperatures very well. It has further been found that the environment 20 if maintained at about 77 K can retain the operability of the junctions and yet acquire the benefits of the lower temperatures. This coupled with the fact that for the conductors 15, 16 and 17 there are a class of superconductor materials that have their transition temperatures (T_{c}) to superconductivity in the vicinity of and above 77 K. Such a conductor and type of transistor combination is then maintained at the environment 20 by the most plentiful and least expensive gas - nitrogen.

Referring next to FIG. 2, there is shown a blown-up view of the interwiring conductor 15 as it reaches the contact 12. In FIG. 2, the conductor 15 has been broken away to show the top of the contact 12 where ordinarily it would extend to the line 21. The planarization layer 14 is generally as thick as the conductor is made. There is a dimension D which is, in essence, the height of the conductor and this can be kept to an absolute minimum where superconductivity is involved and when the dimension D is kept smaller then the parasitic capacitance is reduced. Similarly, the dimension W which takes up chip area can be made as narrow as possible since with superconductivity there is relatively little need for large conductors and conductors of the order of a tenth of a micron are available. Reduction in W will also reduce parasitic capacitance.

In accordance with the invention, there are a class of superconducting materials that are known generally as high T_{c} superconductors. These materials typically have transition temperatures to superconductivity in the vicinity of 77K or higher and these are suitable for purposes of the invention. The most examined one of these compounds has a transition temperature of as high as 94K and it is made up of yttrium, barium, copper and oxygen in the formula Y₁Ba₂Cu₃O_{7-y} where y is approximately 0.1. This compound is known in the art as the 1-2-3 compound. There are other families of compounds, for example, one of bismuth, strontium, calcium, copper and oxygen, that has a transition temperature of approximately 108K; another of thallium, strontium, calcium, copper and oxygen with a transition temperature of 125K; and still another of lanthanum, strontium, copper and oxygen with a transition temperature of approximately 37K. A discussion of families of superconducting compounds is presented in the Materials Research Society MRS Bulletin, Volume XIV, No. 1, January 1989, pages 45 to 48. The 1-2-3 compounds are generally laid down in thin film form. Thereafter, they will handle temperatures without major change up through around 700°C which may be contrasted with ordinary aluminum conductors that are limited to about 450°C. There is a term known in the art as a process window which involves the temperature and the dwell at that temperature that an individual element that is part of an overall integrated circuit can tolerate and will have to receive in order to be used. One of the advantages of the high T_{c} superconductors is that the process window that accompanies those materials is generally substantially broader than with conventional conductors. The superconductor interconnect wiring may be applied by a variety of vapor deposition techniques. Examples of these techniques are discussed in Materials Research Society, MRS Bulletin, Volume XIV, No. 1, January 1989, pages 58-62. For the thickness or D dimension of FIG. 2, the only requirement is that the conductor 15 be continuous over the topography required. This may mean, depending on the process, as thin a layer as a few tens of nanometers. The film patterning can be accomplished by using thin film etching techniques well employed in the semiconductor field. Because of the thinness of the dimension D, fringing and line sidewall to sidewall capacitance will be greatly reduced, thereby permitting wiring densities only limited by lithographic capability.

What has been described is semiconductor integrated circuit technology employing heterojunction transistors together with at least a first level interconnect wiring of high temperature superconductors, all operated below the transition temperature of the superconductor.

## Claims

1. A semiconductor integrated circuit comprising
a semiconductor chip (1) containing at least one heterojunction device (4), having at least one conductive terminal member (10,11,12) at the surface of the chip (1) and at least one interwiring conductor member (15,16,17) extending from the at least one conductive terminal member (10,11,12) to another conductive terminal member (10,11,12) in a different location (18) of the chip,
wherein the interwiring conductor member (15,16,17) is made of superconducting material with a transition temperature T_{c},
and means are provided, maintaining said integrated circuit during operation at a temperature level, below the transition temperature T_{c}, that does not interfere with the performance of the heterojunction devices (4) on the chip (1),
characterized in,
that the heterojunction device (4) is a bipolar transistor imbedded under the surface of the chip (1) made up of a collector layer (5) within the chip, a base layer (6) superimposed thereon and an emitter layer (7) occupying a smaller area over the base layer (6), wherin the collector layer (5), the base layer (6) and the emitter layer (7) each a conductor (10,11,12) rising to the surface of the chip (1), where each said conductor is connected to one of said interwiring conductor members (15, 16, 17), respectively.

2. A semiconductor integrated circuit according to claim 1, characterized in,
that a passivation layer is interposed between the bipolar transistor and the interwiring conductor members (15, 16, 17), wherein the conductors (10, 11, 12) extend therethrough.

3. A semiconductor integrated circuit according to claim 1, characterized in,
that a planarisation layer (14) of insulating material is interposed between the bipolar transistor and the interwiring conductor members (15, 16, 17), wherein the conductors (10, 11, 12) extend therethrough.

4. The integrated circuit according to anyone of claims 1 to 3, characterized in, that the different location (18) is on an additional wiring plane.

5. The integrated circuitaccording to anyone of claims 1 to 4, characterized in, that the superconducting material has a transition temperature T_{c} higher than approximately 77 K.

6. The integrated circuit according to anyone of claims 1 to 5, characterized in
that the heterojunction bipolar transistor (4) is made up of at least one region of silicon forming a heterojunction with a region of silicon-germanium.

7. The integrated circuit according to anyone of claims 1 to 6, characterized in,
that the heterojunction bipolar transistor (4) is made up of at least one region of gallium arsenide forming a heterojunction with a region of gallium aluminum arsenide.

8. The integrated circuit according to anyone one of the claims 1 to 7, characterized in,
that the superconducting material is of the formula
YBa₂Cu₃O_{7-y},
where y is approximately 0,1.

9. The integrated circuit according to one of the claims 1 to 8, characterized in, that the superconducting material is of the family of materials taken from the group of a compound of bismuth, strontium, calcium, copper, and oxygen, a compound of thallium, strontium, calcium, copper and oxygen, and a compound of lanthanum, strontium, copper, and oxygen.

## Patentansprüche

1. Eine Halbleiter integrierte Schaltungstechnik mit einem Halbleiterchip (1), der wenigstens eine Heteroübergangseinheit (4) mit wenigstens einem leitenden Endglied (10, 11, 12) auf der Oberfläche des Chips (1) und wenigstens einen zwischenverdrahteten Leiter (15, 16, 17) hat, der sich von wenigstens einem leitenden Endglied (10, 11, 12) bis zu einem anderen leitenden Endglied (10, 11, 12) an einer anderen Stelle (18) des Chips erstreckt,
wobei der zwischenverdrahtete Leiter (15, 16, 17) aus.supraleitendem Material mit einer Übergangstemperatur T_{c} hergestellt wurde,
und Mittel vorgesehen werden, um den integrierten Schaltkreis während des Betriebs auf einem niedrigen Temperaturniveau, unter der Übergangstemperatur T_{c} zu halten, die nicht die Leistung der Heteroübergangseinheiten (4) auf dem Chip (1) stört,
dadurch gekennzeichnet, daß
die Heteroübergangseinheit (4) ein bipolarer Transistor ist, der in der Oberfläche des Chips (1) eingebettet ist, die aus einer Kollektorschicht (5) im Chip besteht, mit einer überlagerten Grundschicht (6) und einer Emitterschicht (7), die einen kleinen Bereich über der Grundschicht (6) belegt, wobei die Kollektorschicht (5), die Grundschicht (6) und die Emitterschicht (7) jeweils einen Leiter (10, 11, 12) haben, der sich über die Oberfläche des Chips (1) erstreckt, wobei jeder dieser Leiter jeweils mit einem der zwischenverdrahteten Leiter (15, 16, 17) verbunden ist.

2. Eine Halbleiter integrierte Schaltungstechnik gemäß Anspruch 1, dadurch gekennzeichnet,
daß eine Passivierungsschicht zwischen dem bipolaren Transistor und den zwischenverdrahteten Leitern (15, 16, 17) liegt, wobei sich die Leiter (10, 11, 12) durch diese Schicht erstrecken.

3. Eine Halbleiter integrierte Schaltungstechnik gemäß Anspruch 1, dadurch gekennzeichnet,
daß eine Planarisierungsschicht (14) mit Isoliermaterial zwischen dem bipolaren Transistor und den zwischenverdrahteten Leitern (15, 16, 17) liegt, wobei sich die Leiter (10, 11, 12) durch diese Schicht erstrecken.

4. Die integrierte Schaltungstechnik gemäß irgendeinem der Ansprüche 1 bis 3, die dadurch gekennzeichnet ist, daß sich die unterschiedliche Stelle (18) auf einer zusätzlichen Verdrahtungsebene befindet.

5. Die integrierte Schaltungstechnik gemäß irgendeinem der Ansprüche 1 bis 4, die dadurch gekennzeichnet ist, daß das supraleitende Material eine Übergangstemperatur T_{c} größer als ca. 77 K hat.

6. Die integrierte Schaltungstechnik gemäß irgendeinem der Ansprüche 1 bis 5, die dadurch gekennzeichnet ist,
daß der bipolare Heteroübergangstransistor (4), der wenigstens in einem Bereich aus Silizium besteht, einen Heteroübergang mit einem Bereich aus Silizium-Germanium bildet.

7. Die integrierte Schaltungstechnik gemäß irgendeinem der Ansprüche 1 bis 6, dadurch gekennzeichnet,
daß der bipolare Heteroübergangstransistor (4), der wenigstens in einem Bereich aus Galliumarsenid besteht, einen Heteroübergang mit einem Bereich aus Gallium-Aluminium-Arsenid bildet.

8. Die integrierte Schaltungstechnik gemäß irgendeinem der Ansprüche 1 bis 7, dadurch gekennzeichnet,
daß das supraleitende Material die Formel
Yby₂Cu₃O_{7-y1}
ergibt, wobei y etwa 0,1 ist.

9. Die integrierte Schaltungstechnik gemäß irgendeinem der Ansprüche 1 bis 8, dadurch gekennzeichnet, daß das supraleitende Material aus der Familie mit Materialien, die aus der Gruppe aus einer Mischung von Bismut, Strontium, Calcium, Kupfer und Sauerstoff, einer Mischung aus Thallium, Strontium, Calcium, Kupfer und Sauerstoff, und einer Mischung aus Lanthan, Strontium, Kupfer und Sauerstoff herausgenommen werden.

## Revendications

1. Circuit intégré semi-conducteur, comprenant:
une microplaquette semi-conductrice (1) contenant au moins un dispositif à hétérojonctions (4) ayant au moins un élément de terminaison conducteur (10, 11, 12) à la surface de la microplaquette (1) et au moins un élément conducteur d'interconnexion (15, 16, 17) s'étendant depuis au moins un élément de terminaison conducteur (10, 11, 12) jusqu'à un autre élément de terminaison conducteur (10, 11, 12) dans un emplacement différent (18) de la microplaquette,
dans lequel l'élément conducteur d'interconnexion (15, 16, 17) est fait dans un matériau supraconducteur ayant une température de transition T_{c},
et il est fourni des moyens maintenant ledit circuit intégré durant l'opération à un niveau de température, en-dessous de la température de transition T_{c}, qui n'interfère pas avec la performance des dispositifs à hétérojonctions (4) sur la microplaquette (1),
caractérisé en ce que
le dispositif à hétérojonctions (4) est un transistor bipolaire enterré sous la surface de la microplaquette (1) constitué d'une couche de collecteur (5) dans la microplaquette, d'une couche de base (6) qui lui est superposée et d'une couche d'émetteur (7) occupant une plus petit superficie sur la couche de base (6), dans lequel la couche de collecteur (5), la couche de base (6) et la couche d'émetteur (7) ont chacune un conducteur (10, 11, 12) s'élevant jusqu'à la surface de la microplaquette (1), où chacun desdits conducteurs est respectivement connecté à l'un desdits membres conducteurs d'interconnexion (15, 16, 17).

2. Circuit intégré semi-conducteur selon la revendication 1, caractérisé en ce que
une couche de passivation est intercalée entre le transistor bipolaire et les éléments conducteurs d'interconnexion (15, 16, 17), dans laquelle s'étendent les conducteurs (10, 11, 12).

3. Circuit intégré semi-conducteur selon la revendication 1, caractérisé en ce que
une couche d'aplanissement (14) de matériau isolant est intercalée entre le transistor bipolaire et les éléments conducteurs d'interconnexion (15, 16, 17) dans laquelle s'étendent les conducteurs (10, 11, 12).

4. Circuit intégré selon l'une quelconque des revendications 1 à 3, caractérisé en ce que
l'emplacement différent (18) est sur un plan de câblage supplémentaire.

5. Circuit intégré selon l'une quelconque des revendications 1 à 4, caractérisé en ce que
le matériau supraconducteur a une température de transition T_{c} supérieure à approximativement 77 K.

6. Circuit intégré selon l'une quelconque des revendications 1 à 5, caractérisé en ce que
le transistor bipolaire à hétérojonctions (4) est constitué d'au moins une région de silicium formant une hétérojonction avec une région de silicium-germanium.

7. Circuit intégré selon l'une quelconque des revendications 1 à 6, caractérisé en ce que
le transistor bipolaire à hétérojonctions (4) est constitué d'au moins une région d'arséniure de gallium formant une hétérojonction avec une région d'arséniure de gallium - aluminium.

8. Circuit intégré selon l'une quelconque des revendications 1 à 7, caractérisé en ce que
le matériau supraconducteur a comme formule
Y₁Ba₂Cu₃O_{7-y}
où y est approximativement 0,1.

9. Circuit intégré selon l'une quelconque des revendications 1 à 8, caractérisé en ce que
le matériau supraconducteur est de la famille de matériaux pris dans le groupe d'un composé de bismuth, de strontium, de calcium, de cuivre et d'oxygène, d'un composé de thallium, de strontium, de calcium, de cuivre et d'oxygène, et d'un composé de lanthane, de strontium, de cuivre et d'oxygène.
